# EUROPEAN PATENT APPLICATION

(11) **EP 4 524 682 A1**
(43) Date of publication of application: **19.03.2025**
(21) Application number: 23820158.6
(22) Date of filing: 12.06.2023
(51) Int. Cl.: G06F 1/18, G06F 1/16, H05K 9/00

(54) **ELECTRONIC DEVICE INCLUDING NOISE REDUCTION MEMBER**

(30) Priority: 10.06.2022 KR 20220070951; 13.07.2022 KR 20220086424
(71) Applicant: Samsung Electronics Co., Ltd., Suwon-si, Gyeonggi-do 16677 (KR)
(72) Inventor: CHOI, Ko, Suwon-si, Gyeonggi-do 16677 (KR); GU, Yeonghun, Suwon-si, Gyeonggi-do 16677 (KR); PARK, Youngho, Suwon-si, Gyeonggi-do 16677 (KR); LEE, Seokwoo, Suwon-si, Gyeonggi-do 16677 (KR); JUNG, Kio, Suwon-si, Gyeonggi-do 16677 (KR); LEE, Jiwoo, Suwon-si, Gyeonggi-do 16677 (KR); KIM, Jeongseob, Suwon-si, Gyeonggi-do 16677 (KR)
(74) Representative: Gulde & Partner
(86) International application number: PCT/KR2023/008030
(87) International publication number: WO 2023/239223

(57) **Abstract**

An electronic device including a noise reduction member is disclosed. The electronic device may comprise a speaker and an antenna. The speaker may comprise: a speaker core for generating sound in a first direction; a speaker housing at least partially enclosing the exterior of the speaker core, and comprising a speaker hole which is formed in a position where the hole overlaps with the speaker core with respect to the first direction, the hole being open in the first direction; and a noise reduction member including a conductive material and positioned on the outer surface of the speaker housing. The noise reduction member may comprise: a shielding member having an opening formed by opening a region on a surface perpendicular to the first direction, the region at least partially overlapping the speaker core, and the shielding member comprising the conductive material surrounding the outer perimeter of the speaker hole on the outer surface of the speaker housing; and a conductive extension part formed by extension of the conductive material from the shielding member and having a grounded end.

## Description

### [Technical Field]

Various embodiments disclosed in this document relate to an electronic device and, more particularly, to an electronic device including a speaker and an antenna.

### [Background Art]

Electronic devices may include an antenna to perform functions such as wireless communication (e.g., wireless local area network (WLAN), Bluetooth, long-term evolution (LTE), or 5G) and/or sensing (e.g., touch detection, digitizer, or fingerprint detection). The antenna may be exposed to the outside, but may be provided inside the housing of the electronic device for miniaturization of the electronic device and improvement of appearance thereof.

Electronic devices may also include a voice output device for outputting voice. The voice output device may include a device that converts electrical waves into sound waves by a coil driven by electromagnetic induction or a magnet, such as a speaker. The speaker may be located outside the electronic device, but may be provided inside the housing of the electronic device to increase mobility of the electronic device. With the trend of miniaturization and increased mobility of electronic devices, the difficulty of arranging components provided inside the electronic device is increasing.

### [Disclosure of Invention]

### [Solution to Problem]

In order to miniaturize an electronic device, a speaker and an antenna may be disposed adjacent to each other inside the housing of the electronic device. Electromagnetic noise generated from the voice output device may cause electromagnetic interference (EMI) to the adjacent antenna during the operation of the speaker. Therefore, during the operation of the speaker, the performance of components, such as a wireless communication device or a sensor, of an electronic device that use an antenna disposed adjacent to the speaker may deteriorate, or the components may malfunction.

Various embodiments disclosed in this document may provide an electronic device that is miniaturized and reduces electromagnetic interference to the antenna, thereby improving the performance of the antenna.

An electronic device according to various embodiments of the disclosure may include a speaker and an antenna, wherein the speaker may include a speaker core configured to generate sound in a first direction, a speaker housing configured to at least partially enclose the exterior of the speaker core and including a speaker hole that is formed at a position where the speaker hole overlaps the speaker core with respect to the first direction and is open in the first direction, and a noise reduction member including a conductive material and positioned on an outer surface of the speaker housing, and wherein the noise reduction member may include a shielding member having an opening formed by opening a region that at least partially overlaps the speaker core on a surface perpendicular to the first direction, and including the conductive material configured to surround an outer perimeter of the speaker hole on the outer surface of the speaker housing, and a conductive extension part formed by extension of the conductive material from the shielding member and having an end to be grounded.

A speaker according to another aspect of the disclosure is a speaker for an electronic device including an antenna, which may include a speaker core configured to generate sound in a first direction, a speaker housing configured to at least partially enclose the exterior of the speaker core and including a speaker hole that is formed at a position where the speaker hole overlaps the speaker core with respect to the first direction and is open in the first direction, and a noise reduction member including a conductive material and positioned on an outer surface of the speaker housing, wherein the noise reduction member may include a shielding member having an opening formed by opening a region that at least partially overlaps the speaker core on a surface perpendicular to the first direction, and including the conductive material configured to surround an outer perimeter of the speaker hole on the outer surface of the speaker housing, and a conductive extension part formed by extension of the conductive material from the shielding member and having an end to be grounded.

According to various embodiments disclosed in this document, since the energy of electromagnetic noise generated from the speaker is discharged to the ground by a noise reduction member, the electromagnetic interference of the speaker to the antenna may be reduced, thereby improving the performance of the antenna.

### [Brief Description of Drawings]

In connection with the description of the drawings, the same or similar reference numerals may be used for the same or similar components.
FIG. 1 is a block diagram of an electronic device 101 in a network environment 100 according to various embodiments.
FIG. 2A is a perspective view of an electronic device according to various embodiments of the disclosure.
FIG. 2B is a bottom plan view of an electronic device according to various embodiments of the disclosure.
FIG. 3A is a cross-sectional view of an electronic device according to various embodiments of the disclosure.
FIG. 3B is a cross-sectional view of an electronic device viewed from another direction according to the disclosure.
FIG. 4 is a cross-sectional view illustrating a speaker core of an electronic device according to some embodiments of the disclosure.
FIG. 5 is a schematic diagram illustrating a speaker and antenna of an electronic device of the disclosure.
FIG. 6A is a perspective view illustrating a speaker of an electronic device according to another embodiment of the disclosure.
FIG. 6B is a perspective view illustrating a noise reduction member of an electronic device according to another embodiment of the disclosure.
FIG. 6C is a perspective view illustrating a noise reduction member of an electronic device viewed from another direction according to another embodiment of the disclosure.
FIG. 7 is a graph showing comparison of noise generated in electronic devices between the embodiment of the disclosure and a comparative example.

### [Mode for the Invention]

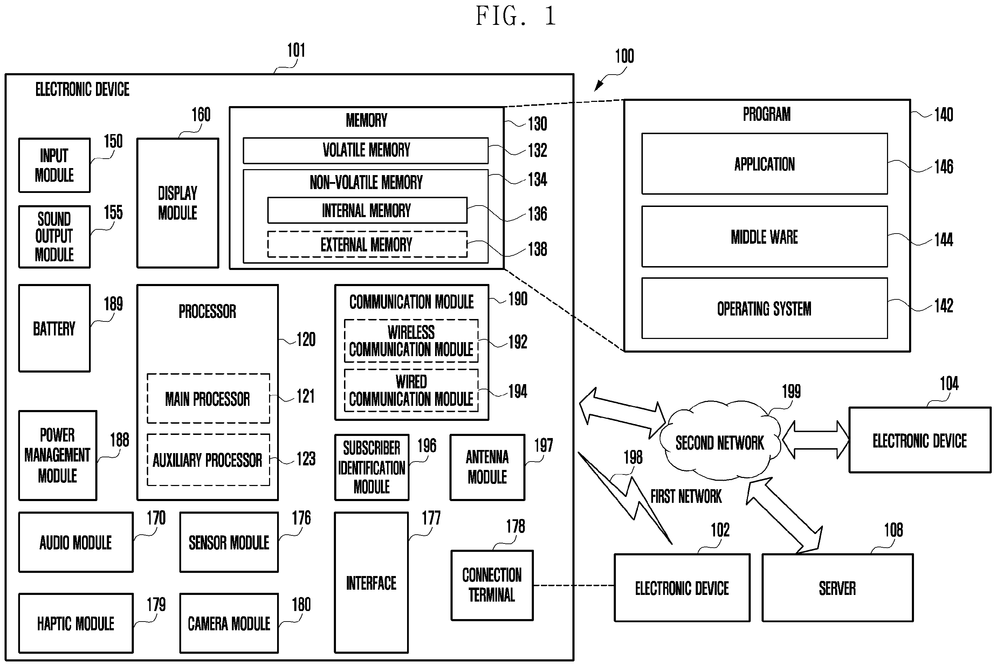

Fig. 1 is a block diagram illustrating an electronic device 101 in a network environment 100 according to various embodiments. Referring to Fig. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thererto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as BluetoothTM, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197. According to various embodiments, the antenna module 197 may form a mm Wave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

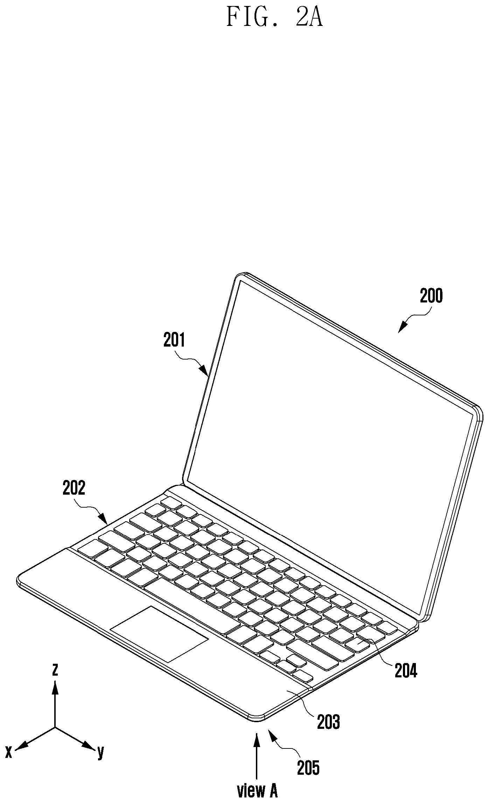

FIG. 2A is a perspective view of an electronic device 200 according to various embodiments of the disclosure.

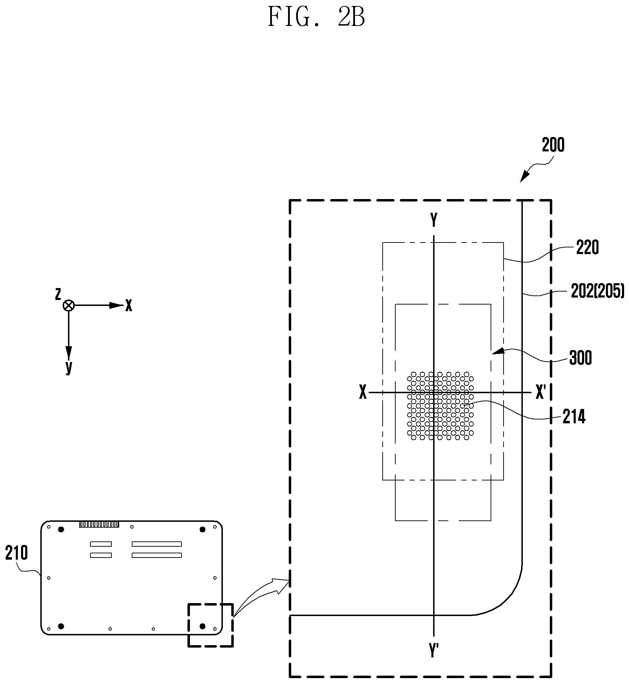

FIG. 2B is a bottom plan view of an electronic device 200 according to various embodiments of the disclosure.

FIG. 2B is a plan view of an electronic device 200 viewed from direction A in FIG. 2A.

Referring to FIG. 2A, the electronic device 200 (e.g., the electronic device 101 in FIG. 1) according to various embodiments may include a display part 201 and a body part 202. For example, the display part 201 may include a display (e.g., the display device 160 in FIG. 1) on one side thereof, and the body part 202 may include an input device 204 (e.g., the input device 150 in FIG. 1) (e.g., a keyboard) on one side thereof. The body part may include various internal components of the electronic device (e.g., the processor 120, the memory 130, the sound output module 155, the sensor module 176, the wireless communication module 192, and the antenna module 197 in FIG. 1). In some embodiments, the body part 202 may include an upper housing 203 and a lower housing 205 that form an inner space of the body part 202 and protect components disposed inside the body part 202 from external impact and foreign substances. The upper housing 203 may be placed in the upper portion of the lower housing 205 (in the z-axis direction) when the electronic device 200 is used.

Referring to FIG. 2B, the electronic device 200 according to various embodiments may include a speaker 300 and an antenna 220 inside the body part 202. The speaker 300 may output sound signals to the outside under the control of a processor (e.g., the processor 120 in FIG. 1) and/or an audio module (e.g., the audio module 170 in FIG. 1) of the electronic device 200. The antenna 220 (e.g., the antenna module 197 in FIG. 1) may transmit and receive electromagnetic signals for communication of the wireless communication module (e.g., the wireless communication module in FIG. 1). In another embodiment, the antenna 220 may receive an electromagnetic signal (e.g., a change in the electromagnetic environment such as a change in capacitance) for the operation of a sensor module (e.g., the sensor module 176 in FIG. 1).

The lower housing 205 may include a speaker grill 214 to enable the sound signal to be effectively output from the speaker 300 to the outside. The speaker grill 214 may be a single opening, but may also be a speaker grill 214 including a plurality of openings as shown in FIG. 2B. For example, the speaker grill 214 may be formed by perforating a plurality of openings in the lower housing 205. The speaker 300 and the antenna 220 may be disposed to at least partially overlap each other when viewed in the upward direction (z-axis direction), thereby saving the inner space of the electronic device 200.

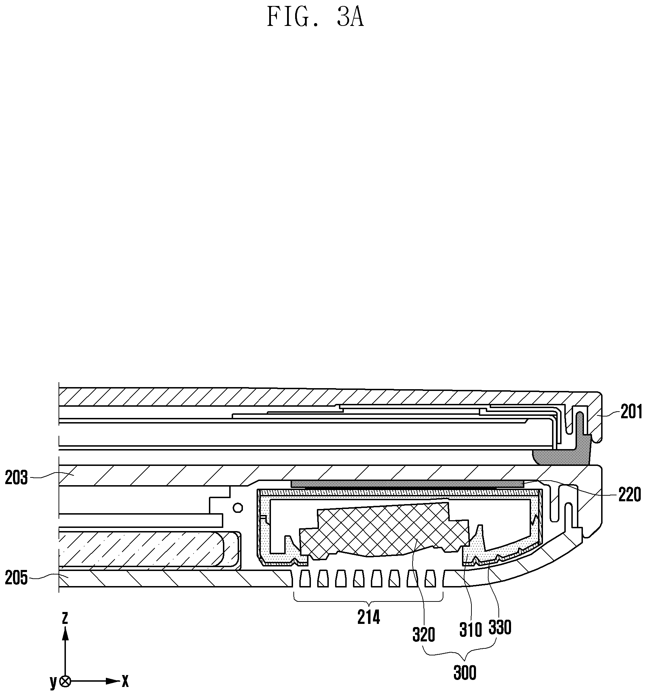

FIG. 3A is a cross-sectional view of an electronic device 200 according to various embodiments of the disclosure.

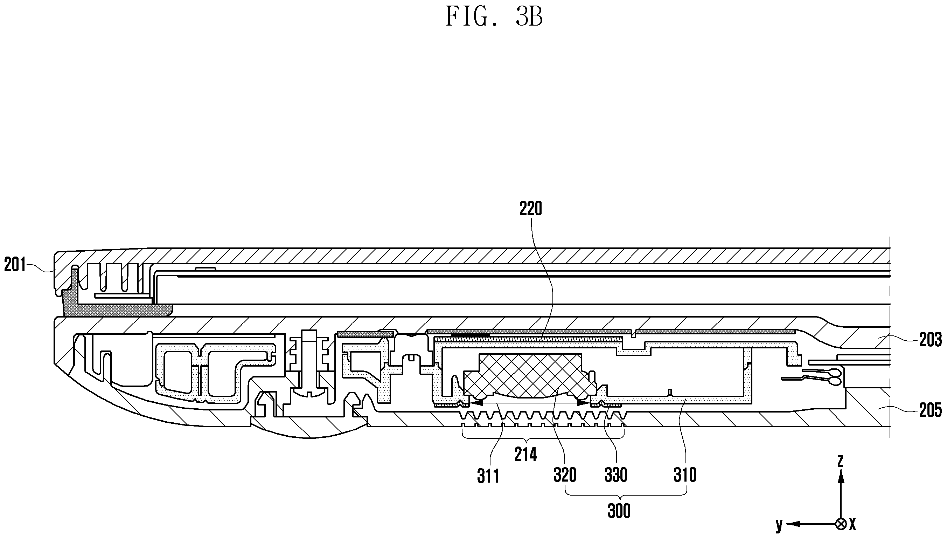

FIG. 3B is a cross-sectional view of an electronic device 200 viewed from another direction according to the disclosure.

The cross-section in FIG. 3A is taken along line X-X' in FIG. 2B, and the cross-section in FIG. 3B is taken along line Y-Y'.

Referring to FIGS. 3A and 3B, a body part 202 of the electronic device 200 may include a speaker 300 and an antenna 220. The speaker 300 may include a speaker core 320, a speaker housing 310, and a noise reduction member 330. The speaker core 320 may be a device that generates sound toward the lower portion of the electronic device 200 (e.g., in a direction opposite the z-axis direction) by electrical signals containing sound information. The speaker housing 310 may be a member that encloses and protects at least a portion of the exterior of the speaker core 320. The speaker housing 310 may include a speaker hole 311 that is formed at a position where the speaker hole 311 overlaps the speaker core 320 with respect to the sound generation direction (the opposite direction of the z-axis direction) of the speaker core 320, for example, on the lower surface of the speaker housing 310 (in the opposite direction the z-axis direction) so as to be open in the sound generation direction (the opposite direction of the z-axis direction) of the speaker 300. The noise reduction member 330 may be a member that is positioned on the outer surface of the speaker housing 310 and reduces electromagnetic noise generated from the speaker core 320. The detailed configuration and operation of the noise reduction member 330 will be described later.

The antenna 220 may be positioned to at least partially overlap the speaker 300. For example, the antenna 220 may be positioned above the speaker 300 (in the z-axis direction). In some embodiments, the antenna 220 may be a printed-type antenna 220. For example, the antenna 220 may include an antenna substrate 221 including a PCB (printed circuit board) or an FPCB (flexible printed circuit board), and an antenna pattern 222 printed and formed on the antenna substrate 221. Since the antenna 220 includes the antenna pattern 222 printed on the antenna substrate 221, a miniaturized antenna 220 having a relatively small size and a relatively high gain, compared to a dipole or monopole antenna 220, may be provided. In addition, since the printed-type antenna 220 has a flat shape, it may be easily disposed to overlap internal components of an electronic device 200, such as the speaker 300, thereby facilitating miniaturization of the electronic device 200.

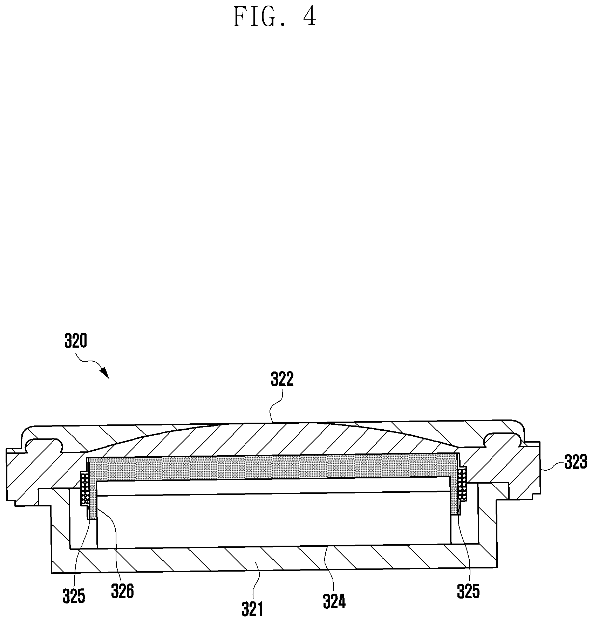

FIG. 4 is a cross-sectional view illustrating a speaker core 320 of an electronic device 200 according to some embodiments of the disclosure.

Referring to FIG. 4, the speaker core 320 according to some embodiments may include a yoke 321, a frame 323, a vibrator 322, a permanent magnet 324, a voice coil 325, and a bobbin 326. The vibrator 322 may be a member that vibrates by an electric signal including an sound signal to generate sound. The vibrator 322 may include a polymer film, pulp, carbon fiber, or various elastic materials similar thereto. The frame 323 may be a member that fixes the vibrator 322 and the bobbin 326 to be described below. The voice coil 325 may be a part that is wound around the outer circumference of the bobbin 326 and magnetized by an electric signal to generate vibration. The vibration generated in the voice coil 325 may vibrate the vibrator 322 to generate sound. The permanent magnet 324 may be a member that applies a magnetic force to the magnetized voice coil 325 by generating a magnetic field. The yoke 321 may be a member that fixes the permanent magnet 324. The speaker core 320 in FIG. 4 is exemplary, and it will be apparent to those skilled in the art that the disclosure may include various configurations of speakers 300 driven by magnetic force.

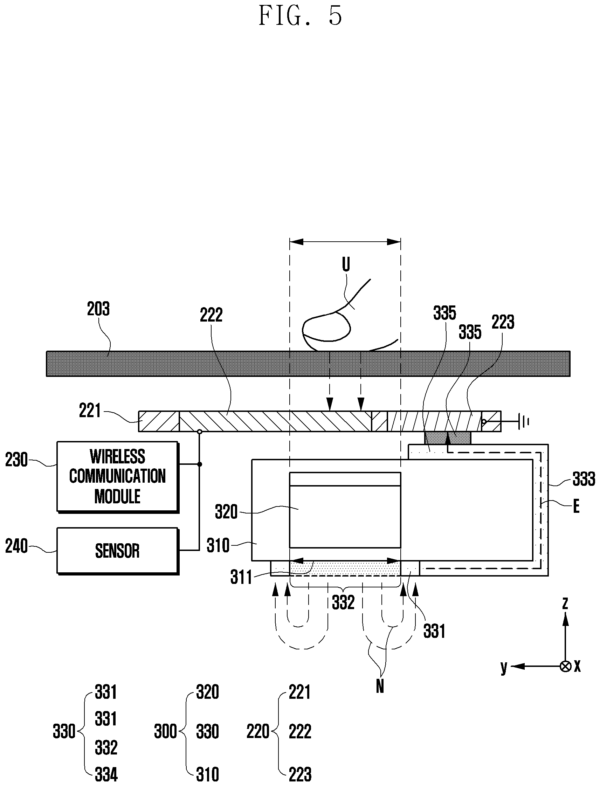

FIG. 5 is a schematic diagram illustrating a speaker 300 and antenna 220 of an electronic device 200 of the disclosure.

Referring to FIG. 5, the noise reduction member 330 may include an opening 332, a shielding member 331, and a conductive extension part 333. The opening 332 may be a portion formed by opening a region of the noise reduction member 330 that at least partly overlaps the speaker core 320, based on the sound generation direction of the speaker core 320 (e.g., in the opposite direction of the z-axis direction). The opening 332 may be disposed to substantially align with the speaker hole 311 of the speaker housing 310. The shielding member 331 may be a member that includes a conductive material and is disposed along the outer perimeter of the speaker hole 311 on the outer surface of the speaker housing 310. The conductive extension part 333 may be a member that is formed by extension of the conductive material of the shielding member 331 and has an end 334 that is grounded. The conductive material may include a metal material (e.g., copper, stainless steel, and/or aluminum), a conductive polymer material, and/or a metal-coated polymer formed by printing or depositing a metal material on a polymer film.

When the speaker core 320 operates, an electromagnetic noise signal generated by an electrical signal applied to the speaker core 320 may be emitted in the sound generation direction (the opposite direction of the z-axis direction) of the speaker core 320 from the speaker core 320. The shielding member 331 may be disposed around the speaker hole 331 through which sound is emitted, and may shield the electromagnetic noise signal. For example, the electromagnetic noise signal may generate an induced current in the conductive member of the shielding member 331 to absorb at least a portion of energy E of the noise signal. That is, the shielding member 331 may act as a pickup for the noise signal. The absorbed energy E of the noise signal may be released to the ground through the conductive extension part 333, so that the noise reduction member 330 may effectively attenuate the noise signal by the speaker core 320. The conductive extension part 333 may be grounded by being electrically connected to, for example, a grounding electrode of an external power source of the electronic device 200, a metal housing, or a grounding electrode of various circuit boards disposed inside the electronic device 200. In some embodiments, the conductive material may include a magnetic material, such as iron, steel, and/or magnetic stainless steel( e.g., ferritic stainless steel and/or martensitic stainless steel), and may further attenuate electromagnetic noise signals by the magnetic-field shielding effect of the magnetic material.

As the noise signal is attenuated, electromagnetic interference to the antenna 220 disposed adjacent to the speaker 300 may be reduced. Therefore, it is possible to minimize the performance degradation of the antenna 220 while disposing the antenna 220 to be adjacent to the speaker 300, thereby facilitating miniaturization of the electronic device 200.

In some embodiments, the antenna 220 may be connected to a wireless communication module 230 (e.g., the wireless communication module 192 in FIG. 1) and/or a sensor 240 (e.g., the sensor module 176 in FIG. 1). The wireless communication module 230 may be a communication module that communicates using communication methods such as 3G, LTE, 5G, Bluetooth, and/or WLAN. The sensor 240 may be, for example, a capacitive touch sensor 240 that detects contact of a user's body U. The antenna 220 may include an antenna substrate 221 and an antenna pattern 222 formed on the antenna substrate 221. In some embodiments, the antenna substrate 221 may include a ground terminal 223. The ground terminal 223 may be a terminal that is grounded and exposed on the surface of the antenna substrate 221 facing the speaker 300. The conductive extension part 333 may extend to the upper surface (the surface facing the z-axis direction) of the speaker housing 310, and the end 334 of the conductive extension part 333 may come into electrical contact with the ground terminal 223 on the upper surface of the speaker housing 310 so as to be grounded. Therefore, since the noise reduction member 330 is grounded together with the antenna substrate 221 without the need for a separate ground wire to be connected to the noise reduction member 330, the material cost may be reduced and the assembling property of the noise reduction member 330 may be improved.

In some embodiments, although the ground terminal 223 and the conductive extension part 333 may make an electrical connection by contact, the ground terminal 223 and the conductive extension part 333 may be electrically connected to each other by a conductive tape 335 in other embodiments. Electrical connection by the conductive tape 335 may be stably maintained by the adhesive force of conductive tape 335 and may facilitate assembly, compared to connection by fastening members such as solder or bolts.

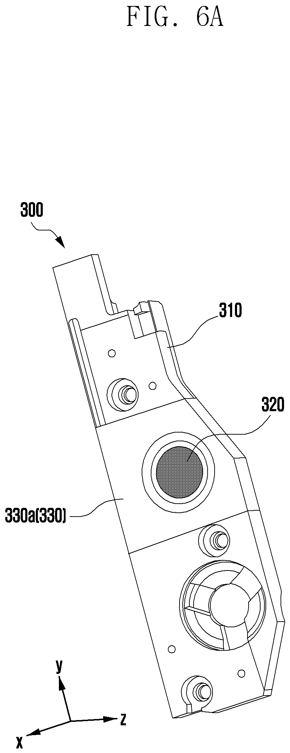

FIG. 6A is a perspective view illustrating a speaker 300 of an electronic device 200 according to another embodiment of the disclosure.

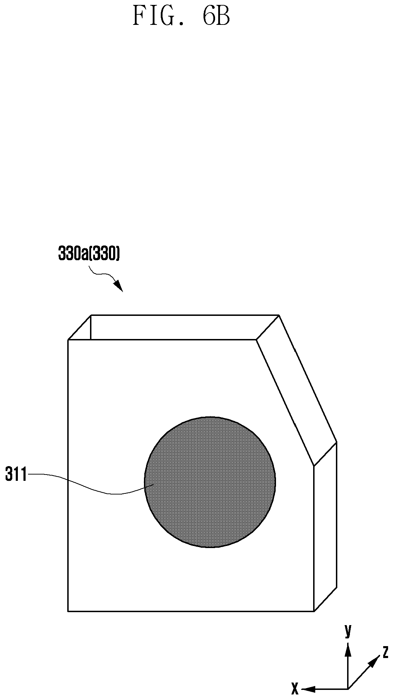

FIG. 6B is a perspective view illustrating a noise reduction member 330 of an electronic device 200 according to another embodiment of the disclosure.

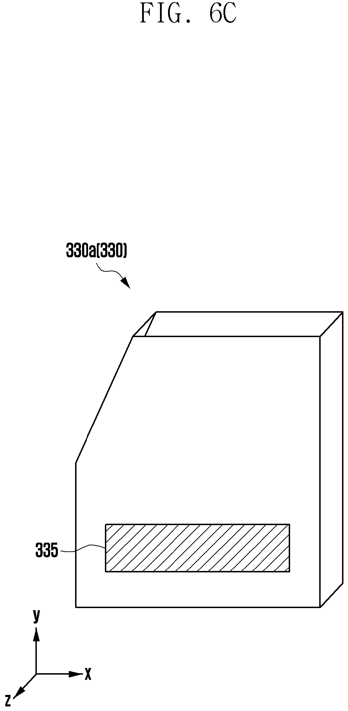

FIG. 6C is a perspective view illustrating a noise reduction member 330 of an electronic device 200 viewed from another direction according to another embodiment of the disclosure.

Referring to FIGS. 6A, 6B, and 6C, the noise reduction member 330 may surround at least a portion of the speaker housing 310 and form a portion of the outer surface of the speaker housing 310. The noise reduction member 330 forming a portion of the outer surface of the speaker housing 310 may be referred to as a shielding housing 330a. The shielding housing 330a may have an opening 332 that is open toward the bottom (in the opposite direction of the z-axis direction), and the opening 332 may be disposed to overlap the speaker core 320. The shielding housing 330a may include a metal material, such as magnetic stainless steel or nonmagnetic stainless steel. The shielding housing 330a made of a metal material may improve the rigidity of the speaker housing 310 as well as attenuating noise generated from the speaker core 320.

A conductive tape 335 may be attached to the opposite side of the direction in which the opening 332 of the shielding housing 330a is formed. The conductive tape 335 may be bonded to the ground terminal 223 of the antenna substrate 221 as described above to electrically connect the shielding housing 330a and the ground terminal 223, thereby grounding the shielding housing 330a.

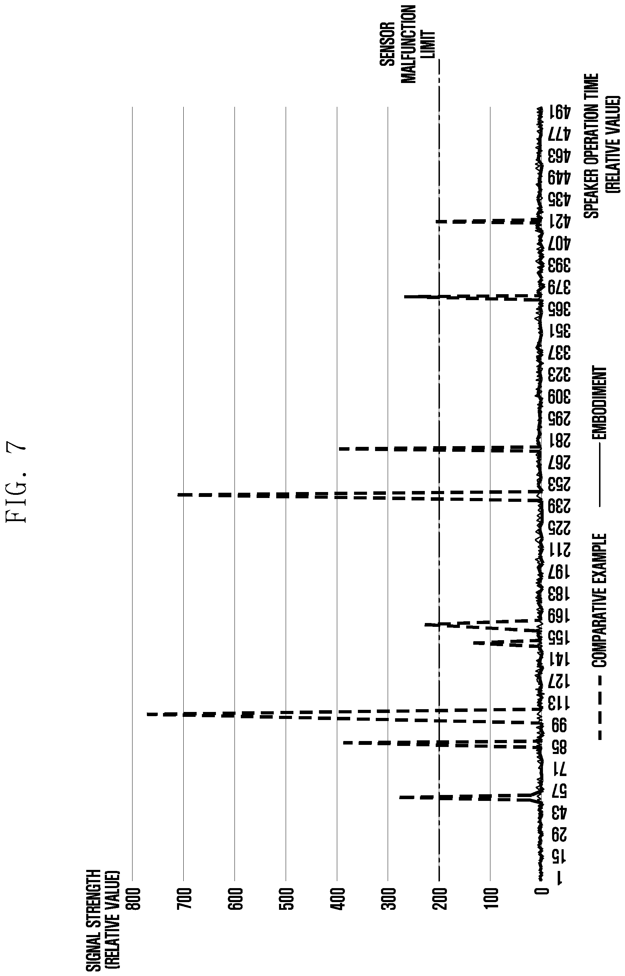

FIG. 7 is a graph showing comparison of noise generated in electronic devices 200 between the embodiment of the disclosure and a comparative example.

Referring to FIG. 7, it can be seen that the electronic device 200 according to the embodiment of the disclosure does not generate a noise signal exceeding the malfunction limit of the sensor 240 connected to the antenna 220 during the operation time of the speaker 300. On the other hand, it can be seen that the electronic device 200 according to the comparative example generates multiple noise signals exceeding the malfunction limit of the sensor 240 during the operation time of the speaker 300. Therefore, during the operation of the speaker 300, a false signal, such as a ghost touch, may be transmitted to the sensor 240 due to electromagnetic interference, thereby causing malfunction of the electronic device 200. The electronic device 200 according to the disclosure may minimize malfunction of the sensor 240 even when the speaker 300 and the antenna 220 are disposed adjacent to each other or to overlap each other, so that the speaker 300 and the antenna 220 may be efficiently disposed inside the electronic device 200.

An electronic device 200 according to various embodiments of the disclosure may include a speaker 300 and an antenna 220, wherein the speaker 300 may include a speaker core 320 configured to generate sound in a first direction, a speaker housing 310 configured to at least partially enclose the exterior of the speaker core 320 and including a speaker hole 311 that is formed at a position where the speaker hole overlaps the speaker core 320 with respect to the first direction and is open in the first direction, and a noise reduction member 330 including a conductive material and positioned on an outer surface of the speaker housing 310. The noise reduction member 330 may include a shielding member 331 having an opening 332 formed by opening a region that at least partially overlaps the speaker core 320 on a surface perpendicular to the first direction, and including the conductive material configured to surround an outer perimeter of the speaker hole 311 on the outer surface of the speaker housing 310, and a conductive extension part 333 formed by extension of the conductive material from the shielding member 331 and having an end 334 to be grounded.

In various embodiments, the conductive extension part 333 may extend onto a surface of the speaker housing 310 facing in a second direction opposite the first direction.

In various embodiments, the noise reduction member 330 may surround at least a portion of the surface of the speaker housing 310 facing in the second direction.

In various embodiments, the antenna 220 may be disposed to overlap at least a portion of the speaker core 320 with respect to the first direction.

In various embodiments, the antenna 220 may be disposed to face the surface of the speaker housing 310 facing in the second direction opposite the first direction.

In various embodiments, the antenna 220 may be a printed-type antenna 220 including an antenna substrate 221 including a printed circuit board or a flexible printed circuit board, and an antenna 220 pattern formed by being printed on the antenna substrate 221.

In various embodiments, the antenna 220 pattern may be disposed to overlap at least a portion of the speaker core 320 with respect to the first direction.

**In** various embodiments, the antenna substrate 221 may include a ground terminal 223 that is grounded and in contact with the end 334 of the conductive extension part 333 on the surface of the antenna substrate 221 facing in the first direction.

**In** various embodiments, a conductive tape 335 configured to bond the ground terminal 223 and the end 334 of the conductive extension part 333 may be further included. **In** various embodiments, the noise reduction member 330 may be a shielding housing 330a made of a metal material that forms at least a portion of the outer surface of the speaker housing 310.

**In** various embodiments, the metal material may include magnetic stainless steel.

A speaker 300 for an electronic device 200 including an antenna 220 according to various embodiments of the disclosure may include a speaker core 320 configured to generate sound in a first direction,
a speaker housing 310 configured to at least partially enclose the exterior of the speaker core 320 and including a speaker hole 311 that is formed at a position where the speaker hole 311 overlaps the speaker core 320 with respect to the first direction and is open in the first direction, and a noise reduction member 330 including a conductive material and positioned on an outer surface of the speaker housing 310. The noise reduction member 330 may include a shielding member 331 having an opening 332 formed by opening a region that at least partially overlaps the speaker core 320 on a surface perpendicular to the first direction, and including the conductive material configured to surround an outer perimeter of the speaker hole 311 on the outer surface of the speaker housing 310, and
a conductive extension part 333 formed by extension of the conductive material from the shielding member 331 and having an end 334 to be grounded.

In various embodiments, the conductive extension part 333 may extend onto a surface of the speaker housing 310 facing in a second direction opposite the first direction.

In various embodiments, the noise reduction member 330 may surround at least a portion of the surface of the speaker housing 310 facing in the second direction.

In various embodiments, the speaker may be disposed to overlap at least a portion of the antenna 220 inside the electronic device 200 when viewed from the first direction.

In various embodiments, the surface of the speaker housing 310 facing in the second direction opposite the first direction may be disposed to face the antenna 220 inside the electronic device 200.

In various embodiments, the antenna 220 may be a printed-type antenna 220 including an antenna substrate 221 including a printed circuit board or a flexible printed circuit board, an antenna 220 pattern formed by being printed on the antenna substrate 221; and a ground terminal 223 exposed on the surface of the antenna substrate 221 in the first direction.

In various embodiments, the end 334 of the conductive extension part 333 may be electrically connected to the ground terminal 223 by extending on the surface of the speaker housing 310 facing in the second direction.

In various embodiments, a conductive tape 335 positioned on the surface of the end 334 of the conductive extension part 333 may be further included to bond the end 334 and the ground terminal 223.

In various embodiments, the noise reduction member 330 may be a shielding housing 330a made of a metal material that forms at least a portion of the outer surface of the speaker housing 310.

In various embodiments, the metal material may include a magnetic stainless steel material.

In addition, the embodiments disclosed in this document disclosed in the specification and drawings are only specific examples presented to easily explain the technical subject matter according to the embodiments disclosed in this document and to help understand the embodiments disclosed in this document, and are not intended to limit the scope of the embodiments disclosed in this document. Therefore, the scope of the various embodiments disclosed in this document should be interpreted as including all changes or modifications derived based on the technical ideas of the various embodiments disclosed in this document, in addition to the embodiments disclosed herein.

## Claims

1. An electronic device comprising a speaker and an antenna,
wherein the speaker comprises:
a speaker core configured to generate sound in a first direction;
a speaker housing configured to at least partially enclose the exterior of the speaker core and comprising a speaker hole that is formed at a position where the speaker hole overlaps the speaker core with respect to the first direction and is open in the first direction; and
a noise reduction member comprising a conductive material and positioned on an outer surface of the speaker housing, and
wherein the noise reduction member comprises:
a shielding member having an opening formed by opening a region that at least partially overlaps the speaker core on a surface perpendicular to the first direction, and comprising the conductive material configured to surround an outer perimeter of the speaker hole on the outer surface of the speaker housing; and
a conductive extension part formed by extension of the conductive material from the shielding member and having an end to be grounded.

2. The electronic device of claim 1,
wherein the conductive extension part extends onto a surface of the speaker housing facing in a second direction opposite the first direction.

3. The electronic device of claim 2,
wherein the noise reduction member surrounds at least a portion of the surface of the speaker housing facing in the second direction.

4. The electronic device of claim 1,
wherein the antenna is disposed to overlap at least a portion of the speaker core with respect to the first direction.

5. The electronic device of claim 4,
wherein the antenna is disposed to face the surface of the speaker housing facing in the second direction opposite the first direction.

6. The electronic device of claim 4,
wherein the antenna comprises:
an antenna substrate comprising a printed circuit board or a flexible printed circuit board; and
an antenna pattern formed by being printed on the antenna substrate.

7. The electronic device of claim 6,
wherein the antenna pattern is disposed to overlap at least a portion of the speaker core with respect to the first direction.

8. The electronic device of claim 6,
wherein the antenna substrate comprises a ground terminal that is grounded and in contact with the end of the conductive extension part on the surface of the antenna substrate facing in the first direction, and
wherein the electronic device further comprises a conductive tape configured to bond the ground terminal and the end of the conductive extension part.

9. The electronic device of claim 1,
wherein the noise reduction member is a shielding housing made of a metal material that forms at least a portion of the outer surface of the speaker housing.

10. A speaker for an electronic device comprising an antenna, the speaker comprising:
a speaker core configured to generate sound in a first direction;
a speaker housing configured to at least partially enclose the exterior of the speaker core and comprising a speaker hole that is formed at a position where the speaker hole overlaps the speaker core with respect to the first direction and is open in the first direction; and
a noise reduction member comprising a conductive material and positioned on an outer surface of the speaker housing,
wherein the noise reduction member comprises:
a shielding member having an opening formed by opening a region that at least partially overlaps the speaker core on a surface perpendicular to the first direction, and comprising the conductive material configured to surround an outer perimeter of the speaker hole on the outer surface of the speaker housing; and
a conductive extension part formed by extension of the conductive material from the shielding member and having an end to be grounded.

11. The speaker of claim 10,
wherein the conductive extension part extends onto a surface of the speaker housing facing in a second direction opposite the first direction, and
wherein the noise reduction member surrounds at least a portion of the surface of the speaker housing facing in the second direction.

12. The speaker of claim 10,
wherein the speaker is disposed to overlap at least a portion of the antenna inside the electronic device when viewed from the first direction.

13. The speaker of claim 12,
wherein the surface of the speaker housing facing in the second direction opposite the first direction is disposed to face the antenna inside the electronic device.

14. The speaker of claim 13,
wherein the antenna is a printed-type antenna comprising:
an antenna substrate comprising a printed circuit board or a flexible printed circuit board;
an antenna pattern formed by being printed on the antenna substrate; and
a ground terminal exposed on the surface of the antenna substrate in the first direction,
wherein the end of the conductive extension part is electrically connected to the ground terminal by extending on the surface of the speaker housing facing in the second direction, and
wherein the speaker further comprises a conductive tape positioned on the surface of the end of the conductive extension part so as to bond the end and the ground terminal.

15. The speaker of claim 10,
wherein the noise reduction member is a shielding housing made of a metal material that forms at least a portion of the outer surface of the speaker housing.
